# EUROPEAN PATENT APPLICATION

(11) **EP 4 746 646 A1**
(43) Date of publication of application: **20.05.2026**
(21) Application number: 24840084.8
(22) Date of filing: 10.07.2024
(51) Int. Cl.: H10H 20/819

(54) **LIGHT-EMITTING ELEMENT AND METHOD FOR MANUFACTURING SAME**

(30) Priority: 11.07.2023 US 202363525997 P; 09.07.2024 US 202418767087
(71) Applicant: Seoul Viosys Co., Ltd., Ansan-si, Gyeonggi-do 15429 (KR)
(72) Inventor: LEE, Joonhee, Ansan-Si Gyeonggi-do 15429 (KR)
(74) Representative: Stolmár & Partner Patentanwälte PartG mbB
(86) International application number: PCT/KR2024/009852
(87) International publication number: WO 2025/014274

(57) **Abstract**

Disclosed herein are a light emitting device and a method of manufacturing the same. According to an embodiment, the light emitting device may include: a second electrode pad; a second semiconductor layer; an active layer; a first semiconductor layer; a first contact layer; and a first electrode pad. The second semiconductor layer is disposed on an upper region of the second electrode pad to be electrically connected to the second electrode pad. The active layer is disposed on an upper region of the second semiconductor layer to generate and emit light. The first semiconductor layer is disposed on an upper region of the active layer. The first contact layer is disposed on an upper region of the first semiconductor layer. The first electrode pad is disposed on an upper region of the contact layer to be electrically connected to the first semiconductor layer through the contact layer. The upper surface of the first semiconductor layer located in a non-light emitting region is placed higher than a light emitting surface corresponding to the upper surface of the first semiconductor layer located in a light emitting region.

## Description

### [Technical Field]

Embodiments of the present disclosure relate to light emitting device and a method of manufacturing the same.

### [Background Art]

A light emitting diode (LED) is a device that converts electrical signals into light using the properties of a semiconductor. Depending on materials used, LEDs can generate and emit different colors of light, including infrared, visible, and ultraviolet light.

An LED includes a semiconductor layer, a growth substrate on which the semiconductor layer is grown, and an electrode.

LEDs may be categorized into vertical LEDs and horizontal LEDs based on the structure thereof.

Vertical LEDs are used to manufacture high-power LED due to higher heat dissipation efficiency than horizontal LEDs.

In general, a vertical LED includes: a first semiconductor layer and a second semiconductor layer doped with different dopants; and an active layer formed therebetween to generate and emit light. In addition, the vertical LED includes a contact layer formed between the first semiconductor layer and the first electrode to reduce contact resistance. Here, in order to ensure that light exits the LED through the first semiconductor layer, an unnecessary region of the contact layer covering the first semiconductor layer in a light emitting region is removed by an etching process. However, since wet etching is isotropic etching, the contact layer can remain on a surface of the first semiconductor layer, that is, a light emitting surface, without being removed by etching. The problem is that the contact layer remaining on the light emitting surface can absorb light generated and emitted from the active layer, causing reduction in luminous efficacy of the LED.

### [Disclosure]

### [Technical Problem]

Embodiments of the present disclosure provide a light emitting device that has improved luminous efficacy through increase in light emitting area.

Embodiments of the present disclosure provide a light emitting device that has improved luminous efficacy by ensuring that as much as possible of light generated by an active layer exits the LED chip.

### [Technical Solution]

In accordance with one aspect of the present disclosure, there is provided a light emitting device including: a second electrode pad; a second semiconductor layer; an active layer; a first semiconductor layer; a first contact layer; and a first electrode pad. The second semiconductor layer is formed on an upper region of the second electrode pad to be electrically connected to the second electrode pad. The active layer is formed on an upper region of the second semiconductor layer to generate and emit light. The first semiconductor layer is formed on an upper region of the active layer. The first contact layer is formed on an upper region of the first semiconductor layer. The first electrode pad is formed on an upper region of the contact layer to be electrically connected to the first semiconductor layer through the contact layer. Here, one of the first semiconductor layer and the second semiconductor layer is an n-type semiconductor layer and the other is a p-type semiconductor layer. The upper surface of the first semiconductor layer located in a non-light emitting region is placed higher than a light emitting surface corresponding to the upper surface of the first semiconductor layer located in a light emitting region. Here, the non-light emitting region is a region in which the contact layer is formed, and the light emitting region is an exposed region on the upper surface of the first semiconductor layer.

The light emitted from the active layer may include visible light or UV light.

A lower surface of the first contact layer may be placed higher than the light emitting surface.

The light emitting surface may be formed with irregularities.

The light emitting device may include an unshaded region allowing light generated therein and emitted therefrom to exit the light emitting device and a shaded region not allowing light generated therein and emitted therefrom to exit the light emitting device.

The light emitting device may further include: an insulating layer formed between the second electrode pad and the second semiconductor layer to cover a region of the second semiconductor layer. The insulating layer may spread electric current injected through the second electrode pad such that the electric current flows evenly throughout the second semiconductor layer and the active layer.

The insulating layer may be formed on a lower region of the second semiconductor layer in the shaded region.

The second electrode pad may contact the second semiconductor layer in the unshaded region.

The first electrode pad may have a smaller cross-sectional area than the first contact layer.

At least a side surface of the first semiconductor layer in the non-light emitting region may include a slope.

At least a side surface of the first contact layer may include a slope.

At least a side surface of the first electrode pad may include a slope.

The light emitting region may partially overlap the shaded region to form an overlapping region.

The upper surface of the first semiconductor layer in the overlapping region may be placed higher than the upper surface of the first semiconductor layer in the light emitting region excluding the overlapping region.

The light emitting device may further include: an insulating layer covering the upper surface of the second electrode pad and comprising a plurality of openings. The second electrode pad may include a plurality of metal layers stacked one above another. The second electrode pad may partially or completely fill each of the plurality of openings of the insulating layer to be electrically connected to the second semiconductor layer.

The light emitting device may further include: an upper current-spreading layer formed on the first semiconductor layer to be electrically connected to a region of the first contact layer. The upper current-spreading layer may include a plurality of divided regions extending from the first contact layer.

At least an opening of the plurality of openings of the insulating layer may include an upper region gradually increased in diameter toward an upper end thereof and a lower region having a constant diameter.

The light emitting device may further include: a second contact layer formed between the second semiconductor layer and the second electrode pad. The second contact layer may be formed in the upper region of the at least an opening to be electrically connected to the second semiconductor layer and the second electrode pad.

An inner surface of the insulating layer forming the upper region of the at least an opening may include a curved surface.

In a region of the light emitting device, the upper current-spreading layer may be disposed at both sides of the first contact layer with a space between the upper current-spreading layer and the first contact layer. Here, the second contact layer may be disposed between the first contact layer and the upper current-spreading layer.

In a region outside the second semiconductor layer, an upper surface of at least a metal layer of the plurality of metal layers may be placed lower than a lower surface of the active layer.

### [Advantageous Effect]

The light emitting device according to the embodiments of the present disclosure has improved luminous efficacy through removal of a light absorbing material from a light emitting surface.

The light emitting device according to the embodiments of the present disclosure has improved luminous efficacy through increase in light emitting area.

The light emitting device according to the embodiments of the present disclosure has improved luminous efficacy that as much as possible of light generated by an active layer exits the LED chip light.

### [Description of Drawings]

FIG. 1 to FIG. 7 are schematic views illustrating a method of manufacturing a light emitting device according to a first embodiment of the present disclosure.
FIG. 8 is a schematic cross-sectional view of a light emitting device according to a second embodiment of the present disclosure.
FIG. 9 is a schematic cross-sectional view of a light emitting device according to a third embodiment of the present disclosure.
FIG. 10 to FIG. 12 illustrates a light emitting device according to a fourth embodiment of the present disclosure.
FIG. 13 is a plan view of a light emitting device according to a fifth embodiment of the present disclosure.
FIG. 14 is a cross-sectional view taken along line A1-A2 of FIG. 13.
FIG. 15 is an enlarged view of region B of FIG. 14.

### [Detailed Description of the Illustrated Embodiments]

Hereinafter, embodiments of the present invention will be described in more detail with reference to the accompanying drawings. It should be understood that the following embodiments are given by way of illustration only to provide thorough understanding of the invention to those skilled in the art. Therefore, the present invention is not limited to the following embodiments and may be embodied in different ways. Further, the widths, lengths, and thicknesses of certain elements, layers or features may be exaggerated for clarity, and like components will be denoted by like reference numerals throughout the specification.

Hereinafter, a light emitting device according to the present disclosure will be described in detail with reference to the accompanying drawings.

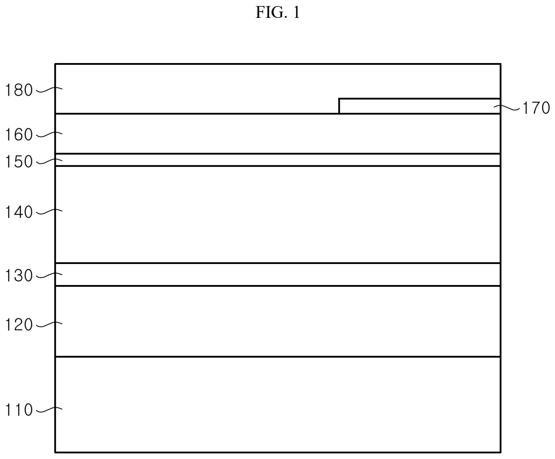

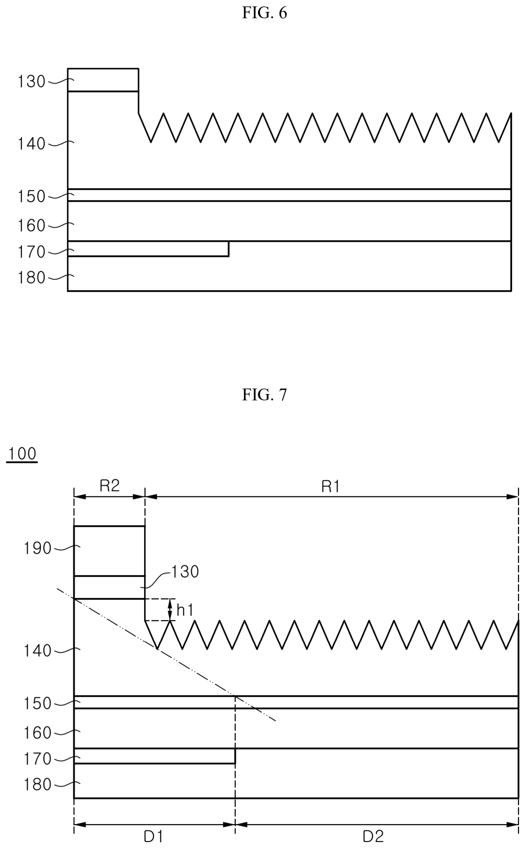

FIG. 1 to FIG. 7 are schematic views illustrating a method of manufacturing a light emitting device according to a first embodiment of the present disclosure. FIG. 7 shows a schematic cross-sectional structure of the light emitting device according to the first embodiment.

The light emitting device 100 according to this embodiment may generate and emit light. The light generated and emitted by the light emitting device 100 may include visible light or UV light. In addition, the light emitting device 100 according to this embodiment may be a vertical light emitting device 100 in which an n-type electrode and a p-type electrode are arranged in a vertical direction.

Referring to FIG. 1, semiconductor layers may be formed on a growth substrate 110.

For example, formation of the semiconductor layers on the growth substrate 110 may be conducted by metal organic chemical vapor deposition (MOCVD).

The growth substrate 110 may be formed of a material that allows a semiconductor layer emitting visible light or UV light to be grown thereon. For example, the growth substrate 110 may be formed of sapphire (Al₂O₃).

A buffer layer 120, a contact layer 130, a first semiconductor layer 140, an active layer 150, and a second semiconductor layer 160 may be sequentially formed on the growth substrate 110.

The buffer layer 120 serves to relieve stress caused by differences in lattice constant and thermal expansion coefficient between the growth substrate 110 and the semiconductor layers formed on the buffer layer 120 to prevent cracking and warpage of the semiconductor layers. For example, the buffer layer 120 may be formed of undoped GaN (u-GaN).

The contact layer 130 may be formed on an upper region of the buffer layer 120. The contact layer 130 serves to reduce contact resistance with an electrode pad that will contact the semiconductor layers later. The contact layer 130 may be formed of a GaN semiconductor doped with an n-type dopant (n-GaN semiconductor). For example, the n-type dopant may include Si.

The first semiconductor layer 140 may be formed on an upper region of the contact layer 130. The first semiconductor layer 140 may be formed of a compound semiconductor doped with an n-type dopant. In addition, the first semiconductor layer 140 may be formed of an AlGaN semiconductor doped with an n-type dopant. For example, the n-type dopant may include Si. In addition, the first semiconductor layer 140 may be more heavily doped with the n-type dopant than the contact layer 130. For example, a doping concentration of the n-type dopent in the first semiconductor layer 140 may be 5×10¹⁸ atoms/cm³ or more.

According to this embodiment, the first semiconductor layer 140 may be formed thicker than a target thickness thereof. For example, the first semiconductor layer 140 may be formed thicker than the target thickness by the thickness of the contact layer 130.

The active layer 150 may be formed on an upper region of the first semiconductor layer 140. The active layer 150 is a layer in which electrons injected through the first semiconductor layer 140 recombine with holes injected through the second semiconductor layer 160 to generate light. Alternatively, the active layer 150 may generate light by recombination of holes injected through the first semiconductor layer 140 and electrons injected through the second semiconductor layer 160.

The active layer 150 may have one of the following structures: a single-well structure, a multi-well structure, a single-quantum well structure, a multi-quantum well (MQW) structure, a quantum dot structure, or a quantum wire structure.

The second semiconductor layer 160 may be formed on an upper region of the active layer 150. The second semiconductor layer 160 may be formed of a compound semiconductor doped with a p-type dopant. For example, the second semiconductor layer 160 may be formed of a GaN semiconductor doped with a p-type dopant.

In addition, a second electrode pad 180 may be formed on an upper region of the second semiconductor layer 160. The second electrode pad 180 may be electrically connected to the second semiconductor layer 160. The second electrode pad 180 may be formed of a conductive material, such as metal. The second electrode pad 180 may have a monolayer structure or a multilayer structure.

According to this embodiment, the second electrode pad 180 may serve as a support substrate to support the semiconductor layers in subsequent processes.

Although the second electrode pad 180 electrically connected to the second semiconductor layer 160 doubles as a support substrate in this embodiment, the present disclosure is not limited thereto. For example, a separate support substrate may be formed on an upper region of the second electrode pad 180. Alternatively, a support substrate may be formed on an upper region of the second semiconductor layer 160 prior to forming the second electrode pad 180. Here, the support substrate may be removed after being used to support the semiconductor layers in various steps of formation of the light emitting device 100. After removal of the support substrate, the second electrode pad 180 may be formed on the second semiconductor layer 160 to be electrically connected to the second semiconductor layer 160.

In addition, a lower current-spreading layer 170 may be formed on an upper region of the second semiconductor layer 160. The lower current-spreading layer 170 serves to spread electric current injected through the second electrode pad 180. Flow of electric current injected through the second electrode pad 180 can be concentrated to a region close to a first electrode pad 190 that will be formed later. As a result, generation and emission of light can be concentrated in a region in which the second electrode pad 180 is close to the first electrode pad 190, and the amount of light output can be reduced with increasing distance between the first electrode pad 190 and the second electrode pad 180. In order to reduce such non-uniformity in light output and achieve uniform luminescence, the lower current-spreading layer 170 serves to allow electric current injected through the second electrode pad 180 to flow evenly throughout the second semiconductor layer 160 and the active layer 150. The lower current-spreading layer 170 may be formed of an insulating material, such as SiO₂. Accordingly, the lower current-spreading layer 170 may serve as an insulating layer to partially isolate the second electrode pad 180 from the second semiconductor layer 160 while serving to spread electric current.

In FIG. 1, the second electrode pad 180 is shown as covering the upper and side surfaces of the lower current-spreading layer 170. However, the structure of the second electrode pad 180 is not limited thereto. For example, the second electrode pad 180 may be formed such that the upper surface of the lower current-spreading layer 170 is exposed.

For ease of description and understanding, in the following drawings, the light emitting device is shown as upside down with respect to the position shown in FIG. 1, and the following description will be given with reference to the corresponding drawings.

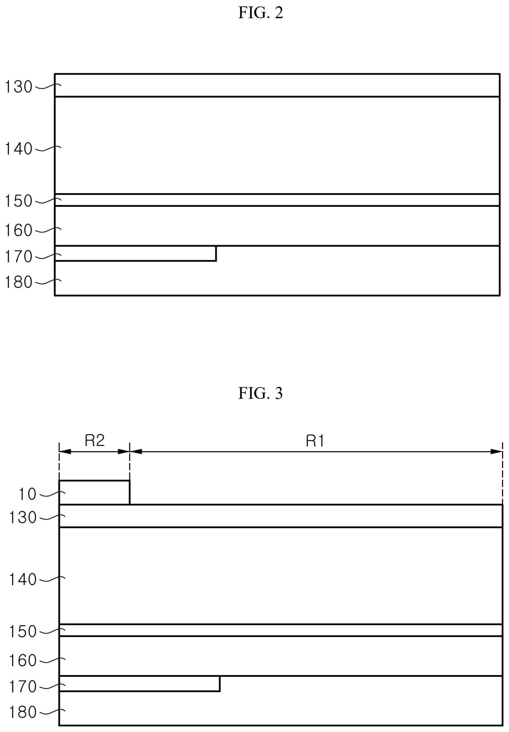

Referring to FIG. 2, the growth substrate 110 and the buffer layer 120 may be removed.

Light generated by the active layer 150 may be emitted in a downward direction (toward the second electrode pad 180) and in an upward direction (toward the first semiconductor layer 140) with reference to FIG. 2. Here, light directed at the second electrode pad 180 may be reflected from the second electrode pad 180 to be redirected in the upward direction. The light generated by the active layer 150 may include visible light or UV light.

The buffer layer 120 may have an energy bandgap that enables absorption of light emitted from the active layer 150. Accordingly, in order to ensure that light from the active layer 150 is directed upwards, the buffer layer 120, which would otherwise absorb the light, needs to be removed.

Referring to FIG. 3 to FIG. 5, the contact layer 130 may be partially removed.

According to this embodiment, the contact layer 130 may also have an energy bandgap that enables absorption of light emitted from the active layer 150. Accordingly, the contact layer 130 formed in a light emitting region R1, through which light exits the LED chip, may be removed, leaving a region of the contact layer 130 on which a first electrode electrically connected to the first semiconductor layer 140 will be formed.

Referring to FIG. 3, a mask 10 may be formed on an upper region of the contact layer 130 to cover a region of the contact layer 130 that will remain without being removed, such as the region of the contact layer 130 on which the first electrode will be formed. That is, the mask 10 may be formed on an upper region of the contact layer 130 located in a non-light emitting region R2.

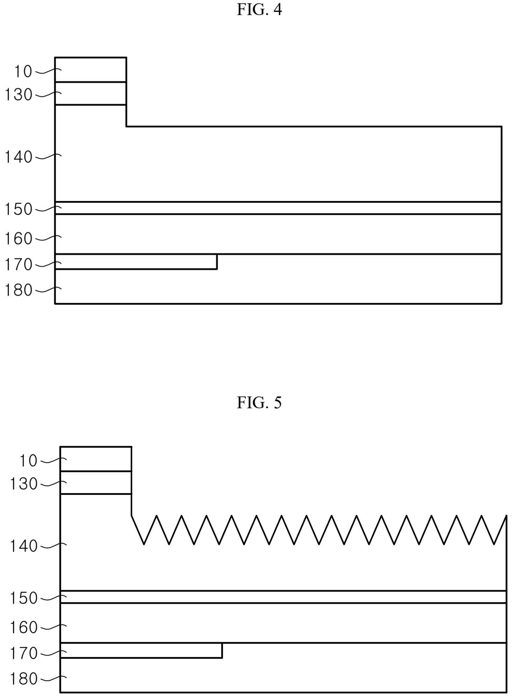

Referring to FIG. 4, a primary etching process may be performed.

According to this embodiment, a region exposed through the mask may be subjected to the primary etching process. For example, the primary etching process may include dry etching using plasma.

According to this embodiment, the primary etching process may remove the exposed region of the contact layer 130. In addition, the primary etching process may allow the first semiconductor layer 140 to have a predetermined target thickness.

According to this embodiment, the primary etching process removes not only the contact layer 130, but also a region of the first semiconductor layer 140 under the contact layer 130. That is, the primary etching process can reliably remove the entirety of the contact layer 130 exposed through the mask 10.

Referring to FIG. 5, a secondary etching process may be performed.

According to this embodiment, the region exposed through the mask 10 may be subjected to the secondary etching process. That is, a surface of the first semiconductor layer 140 exposed through the primary etching process may be subjected to the secondary etching process.

According to this embodiment, the secondary etching process may include wet etching. For example, the secondary etching process may include photo-electrochemical (PEC) etching. An etching solution used in the secondary etching process may include a solution including potassium hydroxide, ammonia, hydrochloric acid, phosphoric acid, or the like.

The secondary etching process may form irregularities, such as ridges and valleys, on the exposed surface of the first semiconductor layer 140. Here, the surface of the first semiconductor layer 140 formed with irregularities may serve as a light emitting surface of the light emitting device 100.

With the light emitting surface formed with irregularities, the light emitting device 100 according to the present disclosure can improve luminous efficacy through increase in light extraction efficiency. That is, the light emitting device 100 can ensure effective light emission from an inside thereof to an outside thereof through increase in critical angle of the light emitting surface.

Typically, removal of the contact layer and formation of irregularities on the first semiconductor layer are conducted simultaneously by wet etching. That is, wet etching is performed with the contact layer formed on the upper region of the first semiconductor layer. Since wet etching is an isotropic etching process involving removing a material in various directions rather than in one direction. Accordingly, wet etching can result in formation of uniform or non-uniform irregularities on the surface of the first semiconductor layer. Here, the contact layer can remain on ridges on the surface of the first semiconductor layer without being removed. As a result, a fraction of light generated inside the light emitting device can be absorbed by the contact layer remaining on the surface of the first semiconductor layer, rather than exiting the light emitting device, since the contact layer has an energy bandgap that enables absorption of light. Thus, conventional light emitting devices suffer from reduction in luminous efficacy due to the remaining contact layer. In addition, conventional light emitting devices suffer from reduction in luminous efficacy as the light emitting area thereof is reduced by the area of the contact layer remaining in a light emitting region thereof.

In the method of manufacturing the light emitting device 100 according to the present disclosure, after the contact layer 130 covering the surface of the first semiconductor layer 140 corresponding to the light emitting surface is completely removed, the surface of the first semiconductor layer 140 exposed by removal of the contact layer 130 is subjected to wet etching to form irregularities thereon. Accordingly, the light emitting device 100 according to the present disclosure can have improved luminous efficacy since the light-absorbing substance remaining on the light emitting surface is reduced. Furthermore, the light emitting device 100 according to the present disclosure can have further improved luminous efficacy since the entire surface of the light emitting region serves as the light emitting surface.

In this embodiment, the mask 10 is used in the primary etching process and the secondary etching process. Here, the type of mask 10 used may be changed depending on the type of etching method used. That is, the type of mask 10 used in the primary etching process and the secondary etching may be selected to be suitable for protection of the contact layer 130 from each etching process.

Referring to FIG. 6, the mask 10 is removed after completion of the etching process.

Referring to FIG. 7, a first electrode pad 190 may be formed on an upper region of the contact layer 130. The first electrode pad 190 may cover the entire upper surface of the contact layer 130.

The first electrode pad 190 may be formed of a conductive material. The first electrode pad 190 may have a monolayer structure or a multilayer structure.

The first electrode pad 190 may be electrically connected to the first semiconductor layer 140 through the contact layer 130.

In the light emitting device 100 according to the present disclosure, a region of the first semiconductor layer 140 under the first electrode pad 190 and the contact layer 130 may have a greater thickness than another region of the first semiconductor layer 140. That is, there is a height difference h1 between the light emitting surface and the non-light emitting surface of the first semiconductor layer 140. Specifically, the non-light emitting surface is placed higher than the light emitting surface. Here, the light emitting surface of the first semiconductor layer 140 refers to a surface allowing light to exit the light emitting device therethrough, and the light emitting surface of the first semiconductor layer 140 refers to a surface not allowing light to exit the light emitting device therethrough. That is, the light emitting surface of the first semiconductor layer 140 corresponds to an exposed surface of the first semiconductor layer 140, and the non-light emitting surface of the first semiconductor layer 140 corresponds to a surface of the first semiconductor layer 140 covered by the contact layer 130.

A fraction of light emitted from the active layer 150 is not allowed to exit the light emitting device by being blocked by the contact layer 130 or the first electrode pad 190. That is, a region not allowing light emitted therefrom to exit the light emitting device due to the presence of the contact layer 130 or the first electrode pad 190 may be a shaded region D1.

According to one embodiment of the present disclosure, the shaded region D1 may correspond to a region inside a point on the active layer 150 that meets a line L extending from one end of a lower surface of the contact layer 130 and passing through a valley on the surface of the first semiconductor layer 140 that is closest to the contact layer 130. When the contact layer 130 is omitted, a reference for defining the shaded region D may be one end of a lower surface of the first electrode pad 190.

Light generated in a region of the active layer 150 corresponding to the shaded region D1 is not allowed to exit the light emitting device by being blocked by the contact layer 130. In addition, generation and emission of light may be concentrated in a region of the active layer 150 corresponding to a region in which the second electrode pad 180 and the second semiconductor layer 160 contact each other.

Accordingly, when the second electrode pad 180 is formed within the shaded region D1, the quantity of light exiting the light emitting device 100 decreases compared to the quantity of light generated in and emitted from the active layer 150. That is, luminous efficacy of the light emitting device 100 decreases with increasing contact area between the second electrode pad 180 and the second semiconductor layer 160 within the shaded region D1. In addition, the quantity of light exiting the light emitting device 100 may decrease with decreasing contact area between the second electrode pad 180 and the second semiconductor layer 160 within an unshaded region D1 since a region of the active layer 150 capable of generating and emitting light decreases.

In the light emitting device 100 according to the present disclosure, the first semiconductor layer 140 has a greater thickness in the non-light emitting region R2 in which the contact layer 130 is formed than in the light emitting region R1 in which the first semiconductor layer 140 is etched to a predetermined target thickness. That is, the upper surface of the first semiconductor layer 140 in the non-light emitting region R2 is placed higher than the upper surface of the first semiconductor layer 140 in the light emitting region R1. Accordingly, the lower surface of the contact layer 130 is placed higher than the light emitting surface, that is, the upper surface of the first semiconductor layer 140 in the light emitting region R1. As the height difference h1 between the lower surface of the contact layer 130 and the light emitting surface increases, the height difference between one end of the lower surface of the contact layer 130 and a valley of the first semiconductor layer closest to the contact layer 130 may also increase. As the height difference between the one end of the lower surface of the contact layer 130 and the valley of the first semiconductor layer closest to the contact layer 130 increases, the tilt angle of a line L passing through the one end and the valley increases. As the tilt angle of the line L increases, the area of the shaded region D1 decreases. As the area of the shaded region D1 decreases, the contact area between the second electrode pad 180 and the second semiconductor layer 160 increases and thus a region of the active layer 150 capable of generating and emitting light also increases. Consequently, the height difference between a region of the first semiconductor layer 140 located under the contact layer 130 and a region of the first semiconductor layer 140 located in the light emitting region R1 can increase the quantity of light generated and emitted from the active layer 150, thereby increasing the quantity of light exiting the light emitting device 100 and thus improving luminous efficacy of the light emitting device 100.

Next, various embodiments of the light emitting device according to the present disclosure will be described. The following description will focus on differences from the light emitting device described above. For details omitted in description of the following embodiments, refer to the previous description.

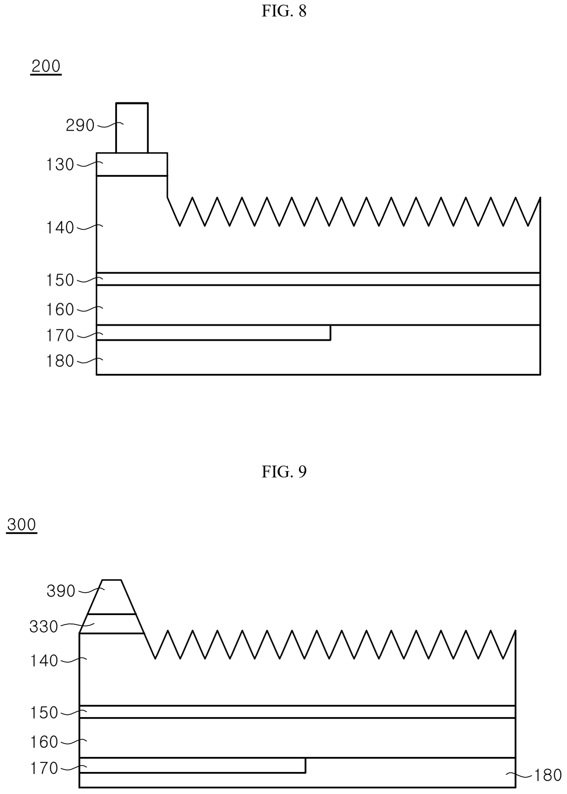

FIG. 8 is a schematic cross-sectional view of a light emitting device according to a second embodiment of the present disclosure.

The light emitting device 200 according to the second embodiment may include a first electrode pad 290, a second electrode pad 180, a contact layer 130, a first semiconductor layer 140, an active layer 150, and a second semiconductor layer 160.

Referring to FIG. 8, the light emitting device 200 according to the second embodiment may have a structure in which the first electrode pad 290 has a smaller width than the contact layer 130.

FIG. 9 is a schematic cross-sectional view of a light emitting device according to a third embodiment of the present disclosure.

The light emitting device 300 according to the third embodiment may include a first electrode pad 390, a second electrode pad 180, a contact layer 330, a first semiconductor layer 340, an active layer 150, and a second semiconductor layer 160.

Referring to FIG. 9, the light emitting device 300 according to the third embodiment may have a structure in which at least a side surface of each of the first electrode pad 390 and the contact layer 330 includes a slope. In addition, at least a region of a side surface of the first semiconductor layer 340 located under the contact layer 330 may include a slope.

According to this embodiment, a fraction of light emitted from a light emitting surface formed with irregularities may strike respective side surfaces of the first electrode pad 390, the contact layer 330, and the first semiconductor layer 340. Here, light incident on the respective side surfaces of the first electrode pad 390, the contact layer 330, and the first semiconductor layer 340 may be reflected from the slopes on the side surfaces without being absorbed to exit the light emitting device 300.

Accordingly, the light emitting device 300 according to this embodiment can minimize absorption of light by the first electrode pad 390, the contact layer 330, and the first semiconductor layer 340, thereby providing improved luminous efficacy.

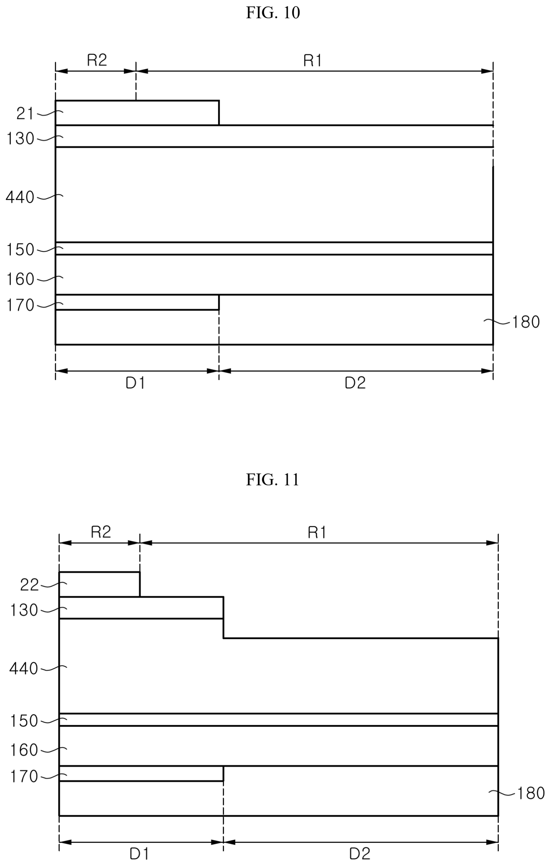

FIG. 10 to FIG. 12 are views illustrating a light emitting device according to a fourth embodiment of the present disclosure.

First, the processes as shown in FIG. 1 and FIG. 2 may provide a structure in which a second semiconductor layer 160, an active layer 150, a first semiconductor layer 440, and a contact layer 130 are sequentially stacked on an upper region of a second electrode pad 180.

Referring to FIG. 10, a primary etching process may be performed.

First, a first mask 21 may be formed on an upper region of the contact layer 130.

The first mask 21 may be formed of a material capable of protecting an etching object from dry etching.

Unlike the mask 10 shown in FIG. 3, the first mask 21 may cover not only the contact layer 130 in a non-light emitting region R2, but also a region of the contact layer 130 in a light emitting region R1. Here, the contact layer 130 in the light emitting region R1 covered by the first mask 21 may be located over a shaded region D1.

The primary etching process may include dry etching, as described in FIG. 4.

The primary etching process may remove both an upper region of the first semiconductor layer 440 and the entirety of a region of the contact layer 130 not covered by the first mask 21.

Referring to FIG. 11, after removal of the first mask 21, a second mask 22 may be formed on the upper region of the contact layer 130. The second mask 22 may be formed of a material capable of protecting an etching object from wet etching.

The second mask 22 may partially cover the contact layer 130. That is, the second mask 22 may cover the contact layer 130 while leaving a region of the contact layer 130 exposed.

After formation of the second mask 22, a secondary etching process may be performed. The secondary etching process may include wet etching.

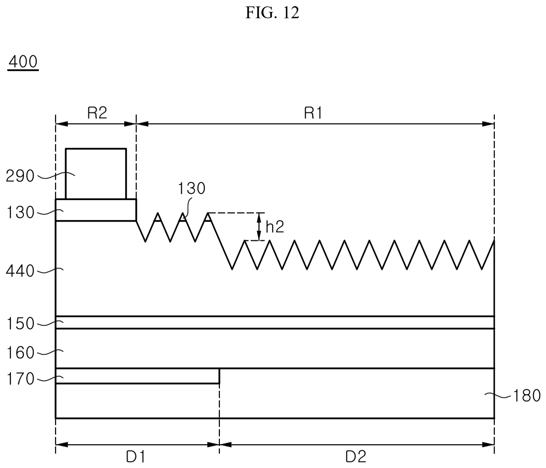

After completion of the secondary etching process, the second mask 22 is removed and the first electrode pad 290 is formed as shown in FIG. 12, thereby forming the light emitting device 400 according to the fourth embodiment.

Referring to FIG. 12, the light emitting device 400 according to this embodiment has a structure in which a region of a light emitting surface located in a shaded region D1 of the light emitting region R1 has a height difference h2 from a region of the light emitting surface located in an unshaded region D2 of the light emitting region R1. That is, the light emitting device 400 may have a structure in which the first semiconductor layer 440 has a greater thickness in the shaded region D1 of the light emitting region R1 than in the unshaded region D2 of the light emitting region R1.

In addition, the shaded region D1 is subjected to only the secondary etching process without being subjected to the primary etching process. The contact layer 130 may remain on ridges of irregularities formed on the surface of the first semiconductor layer through the secondary etching process using wet etching. That is, the light emitting device 400 according to this embodiment may include an overlapping region in which the light emitting region R1 and the shaded region D1 overlap each other. In addition, the light emitting surface formed with irregularities that is located in the overlapping region may be placed higher than the light emitting surface formed with irregularities that is located in the light emitting region R1 excluding the overlapping region. In addition, the contact layer 130 may partially remain on the light emitting surface formed with irregularities that is located in the overlapping region.

In some embodiments, a side surface of the first electrode pad may be spaced apart from an end of the shaded region D1 by a distance of about 20 µm or less. Here, the side surface of the first electrode pad refers to a side surface of the first electrode pad facing the light emitting region R1 and the end of the shaded region D1 refers to a distal end of the shaded region D1 corresponding to an edge thereof.

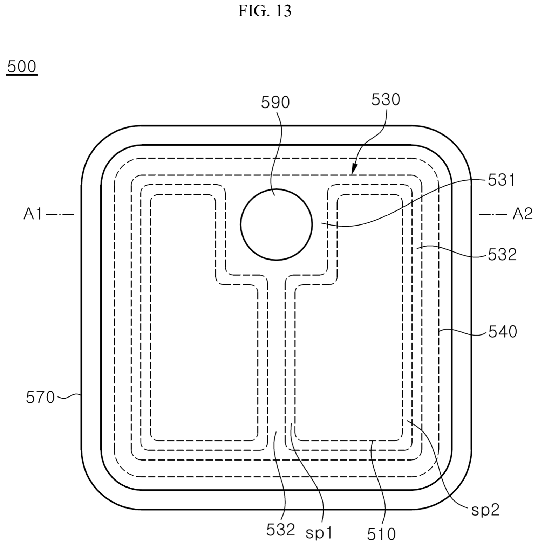

FIG. 13 to FIG. 15 are views illustrating a light emitting device according to a fifth embodiment of the invention.

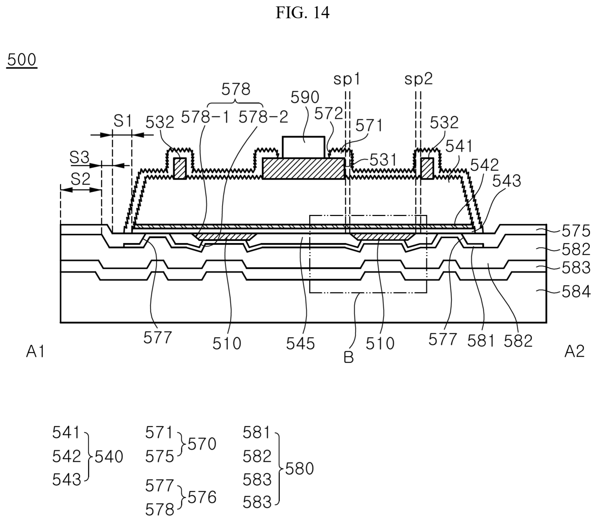

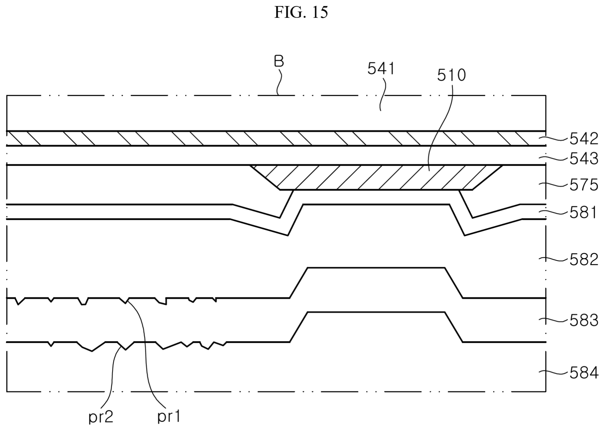

FIG. 13 is a plan view of a light emitting device according to the fifth embodiment. FIG. 14 is a cross-sectional view taken along line A1-A2 of FIG. 13. FIG. 15 is an enlarged view of region B of FIG. 14.

Referring to FIG. 14, the light emitting device 500 according to the fifth embodiment may include a second electrode pad 580, an insulating layer 570, a second contact layer 510, a semiconductor structure 540, a first contact layer 530, and a first electrode pad 590. The second electrode pad 580 may include at least a metal layer. For example, the second electrode pad 580 may include a first metal layer 581, a second metal layer 582, a third metal layer 583, and a fourth metal layer 584. The insulating layer 570 may include a first insulating layer 571 and a second insulating layer 575. The first contact layer 530 may include a contact layer 531 and an upper current-spreading layer 532.

The second electrode pad 580 may be formed of a conductive material, such as metal. In this embodiment, the second electrode pad 580 may be a multilayer structure including first to fourth metal layers 581, 582, 583 and 584

For example, each of the metal layers forming the second electrode pad 580 may include at least a material of titanium (Ti), tungsten (W), platinum (Pt), nickel (Ni), aluminum (Al), or chromium (Cr). In addition, each of the metal layers forming the second electrode pad 580 may include at least a different material than a metal layer adjacent thereto and may have a different coefficient of thermal expansion than a metal layer adjacent thereto.

For example, the first metal layer 581 may include at least a material of titanium (Ti), tungsten (W), platinum (Pt), nickel (Ni), aluminum (Al), or chromium (Cr). In addition, the first metal layer 581 may have a multilayer structure in which a layer formed of titanium (Ti) and a layer formed of tungsten (W) are stacked one above another.

The second metal layer 582 may be disposed on a lower region of the first metal layer 581 and may include at least material of titanium (Ti), tungsten (W), platinum (Pt), nickel (Ni), aluminum (Al), or chromium (Cr). In addition, the second metal layer 582 may be formed of a different material than the first metal layer 581, or may include at least a different material than the first metal layer 581. In addition, the second metal layer 582 may include a material having a different coefficient of thermal expansion than the first metal layer 581.

The third metal layer 583 may be disposed on a lower region of the second metal layer 582 and may include at least a material of titanium (Ti), tungsten (W), platinum (Pt), nickel (Ni), aluminum (Al), or chromium (Cr). In addition, the third metal layer 583 may be formed of a different material than the second metal layer 582 or may include at least a different material than the second metal layer 582. In addition, the third metal layer 583 may include a material having a different coefficient of thermal expansion than the second metal layer 582.

The fourth metal layer 584 may be disposed on a lower region of the third metal layer 583 and may include at least a material of titanium (Ti), tungsten (W), platinum (Pt), nickel (Ni), aluminum (Al), chromium (Cr), or tin (Sn). In addition, the fourth metal layer 584 may be formed of a different material than the third metal layer 583 or may include at least a different material than the third metal layer 583. In addition, the fourth metal layer 584 may include a material having a different coefficient of thermal expansion than the third metal layer 583. For example, the fourth metal layer 584 may have a multilayer structure in which a layer formed of nickel (Ni) and a layer formed of tin (Sn) are stacked one above another.

The third metal layer 583 may cover at least a region of an upper surface of the fourth metal layer 584, and the second metal layer 582 may cover at least a region of an upper surface of the third metal layer 583. In addition, the first metal layer 581 may cover at least a region of an upper surface of the second metal layer 582.

Referring to FIG. 14, the first metal layer 581 may have a distal end disposed between a bottom edge of the semiconductor structure 540 and a first slope c1 of the second metal layer 582. That is, the distal end of the first metal layer 581 may be disposed outside the edge of the semiconductor structure 540 and inside a side surface of the second metal layer 582.

The second insulating layer 575 may be formed on an upper region of the second electrode pad 580. The second insulating layer 575 may cover both an upper surface of the first metal layer 581 and at least a region of the upper surface of the second metal layer 582 that is exposed through the first metal layer 581. Here, the second insulating layer 575 may cover the distal end of the first metal layer 581 while covering the upper surface of the second metal layer 582.

Although the second electrode pad 580 is described as having a multilayer structure including four metal layers in this embodiment, the structure of the second electrode pad 580 is not limited thereto. That is, the second electrode pad 580 may have a monolayer structure, or may have a multilayer structure including two or more metal layers.

The second insulating layer 575 may be formed of an insulating material. For example, the second insulating layer 575 may be formed of at least a material of SiO₂, SiNₓ, or MgFₓ.

In addition, the second insulating layer 575 may include a second opening 576 in the form of a through-hole. The second opening 576 of the second insulating layer 575 may include a 1^{st} second opening 577 and a 2^{nd} second opening 578.

Referring to FIG. 14, the 1^{st} second opening 577 may be gradually decreased or increased in diameter toward a lower end thereof.

In addition, the 2^{nd} second opening 578 may include an upper region 578-1 and a lower region 578-2 having different structures. As shown in FIG. 14, the upper region 578-1 of the 2^{nd} second opening 578 may be gradually decreased in diameter toward a lower end thereof. Here, an inner surface of the upper region 578-1 of the 2^{nd} second opening 578 may include a curved surface in vertical cross-section. In addition, the lower region 578-2 of the 2^{nd} second opening 578 may be gradually increased in diameter toward a lower end thereof.

The second electrode pad 580 may be disposed in the 1^{st} second opening 577. Accordingly, the first metal layer 581 of the second electrode pad 580 may be electrically connected to a second semiconductor layer 543 of the semiconductor structure 540 through the 1^{st} second opening 577. The first metal layer 581 may be brought into contact with the second semiconductor layer 543 of the semiconductor structure 540 to establish electrical connection between the second electrode pad 580 and the second semiconductor layer 543. Alternatively, a conductive material may be interposed between the second semiconductor layer 543 and the first metal layer 581 disposed in the 1^{st} second opening 577.

The second contact layer 510 and the second electrode pad 580 may be disposed in the 2^{nd} second opening 578. The second contact layer 510 may be disposed in the upper region 578-1 of the 2^{nd} second opening 578, and the second electrode pad 580 may be disposed in the lower region 578-2 of the 2^{nd} second opening 578. Accordingly, the second contact layer 510 and the first metal layer 581 may be electrically connected to each other through the 2^{nd} second opening 578.

According to this embodiment, the second contact layer 510 may be disposed on a flat region of the upper surface of the first metal layer 581 to fill a spaced defined by the curved or sloped inner surface of the upper region 578-1 of the 2^{nd} second opening 578. Accordingly, the second contact layer 510 may be gradually increased in width toward an upper end thereof and may have a flat lower surface and a curved or sloped side surface.

The second contact layer 510 may include a structure that is gradually increased or decreased in width toward a lower end thereof. In addition, the second contact layer 510 may include a region having a smaller width than the contact layer 531 and a region having a greater width than the contact layer 531. This structure of the second contact layer 510 including regions having different widths can be effective at spreading electric current.

The second insulating layer 575 may include a plurality of 1^{st} second openings 577 and a plurality of 2^{nd} second openings 578. The 1^{st} second opening 577 may be spaced apart from the 2^{nd} second opening 578 and may be disposed in a lower region between the upper current-spreading layer 532 and a side surface of the semiconductor structure 540. The 2^{nd} second opening 578 may be disposed in a lower region between the contact layer 531 and the upper current-spreading layer 532. The light emitting device 500 may include a plurality of second contact layers 510, wherein the second contact layer 510 may be disposed in a lower region between the contact layer 531 and the upper current-spreading layer 532. Referring to FIG. 14, the plurality of second contact layers 510 may be spaced apart from each other.

Referring to FIG. 14, the second contact layer 510 may include a region having a constant thickness and a region having a variable thickness, wherein the region having a variable thickness may be gradually decreased in thickness toward the contact layer 531 and the upper current-spreading layer 532.

The second contact layer 510 may be formed of a conductive material. For example, the second contact layer 510 may include at least a material of titanium (Ti), tungsten (W), platinum (Pt), nickel (Ni), aluminum (Al), or chromium (Cr). For example, the second contact layer 510 may have a structure in which a layer including silver (Ag) is stacked on a layer including titanium (Ti) and tungsten (W). However, the structure of the second contact layer 510 and the materials forming the second contact layer 510 are not limited thereto. The second contact layer 510 may have various structures, such as a monolayer structure or a multilayer structure including conductive materials.

Referring to FIG. 14, the second contact layer 510 may be disposed between an extension line of a side surface of the contact layer 531 and an extension line of a side surface of the upper current-spreading layer 532. Here, the side surface of the contact layer 531 may face the side surface of the upper current-spreading layer 532. In addition, a side surface of the second contact layer 510 may be spaced apart from the extension line of the side surface of the contact layer 531 by a first spacing distance sp1, and the other side surface of the second contact layer 510 may be spaced apart from the extension line of the side surface of the upper current-spreading layer 532 by a second spacing distance sp2. Here, the first spacing distance sp1 may be different from the second spacing distance sp2.

The second contact layer 510 formed in the 2^{nd} second opening 578 may contact the second semiconductor layer 543 to be electrically connected thereto. Alternatively, a conductive material may be interposed between the second semiconductor layer 543 and the second contact layer 510 formed in the 2^{nd} second opening 578.

As such, the second insulating layer 575 may prevent the second electrode pad 580 and the semiconductor structure 540 from directly contacting each other or being electrically connected to each other in any region other than the second opening 576.

Electric current injected through the second electrode pad 580 may be spread by the second insulating layer 575 to be injected into the second semiconductor layer 543. As such, the second insulating layer 575 may serve as a current-spreading layer. That is, the second insulating layer 575 may correspond to the lower current-spreading layer described in the above embodiments.

The semiconductor structure 540 may be formed on an upper region of the second insulating layer 575. In addition, the semiconductor structure 540 may be gradually increased in width toward a lower end thereof.

The semiconductor structure 540 has a structure in which the second semiconductor layer 543, the active layer 542, and the first semiconductor layer 541 are stacked on the upper region of the second insulating layer 575. Here, the second electrode pad 580 and the second contact layer 510 may be electrically connected to the second semiconductor layer 543 through the second opening 576 of the second insulating layer 575.

For details of materials, structures, manufacturing methods of the first semiconductor layer 541, the active layer 542, and the second semiconductor layer 543, refer to the description of the light emitting devices according to the first to fourth embodiments.

The contact layer 531 and the upper current-spreading layer 532 may be formed on an upper surface of the first semiconductor layer 541, which is an upper layer of the semiconductor structure 540.

Referring to FIG. 13, the contact layer 531 and the upper current-spreading layer 532 may be connected to each other. The upper current-spreading layer 532 connected to the contact layer 531 may be disposed on an upper region of the semiconductor structure 540. That is, the upper current-spreading layer 532 may extend from the contact layer 531 to be divided into several regions. With this structure, the upper current-spreading layer 532 allows electric current injected from the first electrode pad 590 to be injected into the first semiconductor layer 541 by ensuring that the electric current is evenly spread rather than being concentered in a certain region.

The first electrode pad 590 may be formed on an upper region of the contact layer 531. The contact layer 531 may reduce contact resistance between the first semiconductor layer 541 formed on the lower region thereof and the first electrode pad 590 formed on the upper surface thereof.

The first electrode pad 590 may be formed of a conductive material. In addition, the first electrode pad 590 may have a monolayer structure or a multilayer structure. The first electrode pad 590 may be electrically connected to the first semiconductor layer 541 through the contact layer 531.

The first insulating layer 571 may cover the semiconductor structure 540, the contact layer 531, the upper current-spreading layer 532, and the first electrode pad 590. For example, the first insulating layer 571 may be formed of the same material as the second insulating layer 575.

As shown in FIG. 14, the first insulating layer 571 may cover exposed regions of the semiconductor structure 540, the contact layer 531, and the upper current-spreading layer 532. The first insulating layer 571 may include a first opening 572, and the first electrode pad 590 may be disposed in the first opening 572. An upper surface of the first electrode pad 590 may be electrically connected to an external component, such as a circuit board. The first semiconductor layer 541 according to this present embodiment may be formed with irregularities on the upper surface thereof located in a light emitting region. Accordingly, the first insulating layer 571 disposed in the light emitting region to cover the first semiconductor layer 541 may also be formed with irregularities.

In addition, the semiconductor structure 540 may be formed with irregularities on a side surface thereof. In addition, a region of the first insulating layer 571 covering the side surface of the semiconductor structure 540 may be at least partially formed with irregularities. The irregularities formed on the side surface of the semiconductor structure 540 can increase the contact area between the semiconductor structure 540 and the first insulating layer 571, thereby ensuring reliable coupling between the semiconductor structure 540 and the first insulating layer 571.

A lower end of the first insulating layer 571 covering the side surface of the semiconductor structure 540 may contact the second insulating layer 575. Accordingly, the light emitting device 500 according to this embodiment may include a structure in which the insulating layer 570 envelops a lower end of the second semiconductor layer 543. That is, the second semiconductor layer 543 may be covered by the insulating layer 570 on both lower and side surfaces thereof forming the bottom edge thereof.

Referring to FIG. 14, the light emitting device 500 may include a first region S1 and a second region S2 outside the semiconductor structure 540, wherein an upper surface of the first region S1 has a different height than an upper surface of the second region S2. In addition, the light emitting device 500 may include a sloped region S3 having a slope connecting the upper surface of the first region S1 to the upper surface of the second region S2. The first region S1 may be disposed between the semiconductor structure 540 and the second region S2. The second region S2 may be disposed outside the first region S1 to be farther away from the semiconductor structure 540 than the first region S1.

The second metal layer 582 of the second electrode pad 580 may include a first slope C1 in the sloped region S3 connecting the upper surface of the first region S1 to the upper surface of the second region S2. The first slope C1 of the second metal layer 580 allows light emitted from the semiconductor structure 540 and having been incident thereon to be reflected upwards, thereby improving light extraction efficiency of the light emitting device 500.

The first insulating layer 575 may include a second slope C2 in the sloped region S3 connecting the upper surface of the first region S1 to the upper surface of the second region S2. The second slope C2 of the first insulating layer 575 allows light emitted from the semiconductor structure 540 and having been incident thereon to be refracted upwards, thereby improving light extraction efficiency of the light emitting device 500.

Referring to FIG. 14, the first metal layer 581 may have a distal end disposed between the bottom edge of the semiconductor structure 540 and the second slope C2 of the second insulating layer 575. That is, the second insulating layer 575 may cover the distal end of the first metal layer 581, thereby preventing the distal end of the first metal layer 581 from being exposed to external moisture.

In the second region S2, the upper surface of the second electrode pad 580 may be placed lower than the lower surface of the active layer 542. Alternatively, in the second region S2, the upper surface of the insulating layer 570 may be disposed in a region between the upper surface of the active layer 542 and the lower surface of the second semiconductor layer 543.

The second metal layer 582 of the second electrode pad 580 may have a greater thickness than the active layer 542. Here, the thickness refers to a distance between the upper surface and the lower surface of a corresponding layer. Alternatively, both the second metal layer 582 and the second insulating layer 575 may have a greater thickness than the active layer 542.

According to this embodiment, in the second region S2, at least a region of a side surface of the insulating layer 570 may face a side surface of the active layer 542. The insulating layer 570 has a different index of refraction than air. Thus, light traveling in air and having reached the insulating layer 570 may be refracted or reflected at the insulating layer 570. For example, a fraction of light emitted from the active layer 542 and traveling in an outward direction may be directed at the side surface of the insulating layer 570 in the second region S2. Here, the insulating layer 570 may reflect the light upwards.

In the second region S2, a vertical extension line L1 of a region of the first slope C1 of the second metal layer 582 may pass through the bottom edge of the semiconductor structure 540. This structure allows light emitted from the bottom edge of the semiconductor structure 540 to be reflected from the second metal layer 582 and directed upwards.

With the stepped structure of each of the insulating layer 570 and the second electrode pad 580, the light emitting device 500 according to this embodiment can enhance the intensity and quantity of light in the upward direction or within a predetermined beam angle.

In addition, the light emitting device 500 according to this embodiment may have a structure in which the stepped region S2 has a greater width than the non-stepped region S1. Here, the width is a distance between one side surface and the other side surface of a corresponding region.

According to this embodiment, the second metal layer 582 of the second electrode pad 580 may include at least a first protrusion pr1. Referring to FIG. 15, the second metal layer 582 may include a plurality of first protrusions pr1. The first protrusion pr1 may protrude outwards from a surface of the second metal layer 582 that is father away from the semiconductor structure 540, among two surfaces of the second metal layer 582. That is, the first protrusion pr1 may protrude downwards from a lower surface of the second metal layer 582.

The first protrusion pr1 formed on the lower surface of the second metal layer 582 serves to increase the contact area between the second metal layer 582 and the third metal layer 583 adjoining the lower surface of the second metal layer 582. Thus, the first protrusion pr1 ensures reliable coupling between the second metal layer 582 and the third metal layer 583. In addition, the first protrusion pr1 serves to increase the surface area of the second metal layer 582. Thus, the first protrusion pr1 improves heat dissipation efficiency of the light emitting device 500 through increase in heat dissipation area of the second metal layer 582.

According to this embodiment, the third metal layer 583 of the second electrode pad 580 may include at least a second protrusion pr2. Referring to FIG. 15, the third metal layer 583 may include a plurality of second protrusions pr2. The second protrusion pr2 may protrude outwards from a surface of the third metal layer 583 that is father away from the semiconductor structure 540, among two surfaces of the third metal layer 583. That is, the second protrusion pr2 may protrude downwards from a lower surface of the third metal layer 583.

The second protrusion pr2 serves to increase the contact area between the third metal layer 583 and the fourth metal layer 584 adjoining the lower surface of the third metal layer 583, thereby ensuring reliable coupling between the third metal layer 583 and the fourth metal layer 584. In addition, the second protrusion pr2 serves to improve heat dissipation efficiency of the light emitting device 500 through increase in heat dissipation area of the third metal layer 583.

According to this embodiment, at least a second protrusion of the plurality of second protrusions pr2 may correspond in position to the first protrusion pr1. That is, at least a second protrusion of the plurality of second protrusions pr2 may be disposed under one of the plurality of first protrusions pr1, as shown in FIG. 15.

Although some embodiments have been described herein, it should be understood that these embodiments are provided for illustration only and are not to be construed in any way as limiting the present disclosure. Therefore, the scope of the present disclosure should be defined by the appended claims and equivalents thereto.

## Claims

1. A light emitting device comprising:
a second electrode pad;
a second semiconductor layer disposed on an upper region of the second electrode pad to be electrically connected to the second electrode pad;
an active layer disposed on an upper region of the second semiconductor layer to generate and emit light;
a first semiconductor layer disposed on an upper region of the active layer;
a first contact layer disposed on an upper region of the first semiconductor layer; and
a first electrode pad disposed on an upper region of the contact layer to be electrically connected to the first semiconductor layer through the contact layer,
wherein one of the first semiconductor layer and the second semiconductor layer is an n-type semiconductor layer and the other is a p-type semiconductor layer, and
wherein the upper surface of the first semiconductor layer located in a non-light emitting region is placed higher than a light emitting surface corresponding to the upper surface of the first semiconductor layer located in a light emitting region, the non-light emitting region being a region in which the contact layer is disposed, and the light emitting region being an exposed region on the upper surface of the first semiconductor layer.

2. The light emitting device according to claim 1, wherein a lower surface of the first contact layer is placed higher than the light emitting surface.

3. The light emitting device according to claim 2, wherein the light emitting surface includes with irregularities.

4. The light emitting device according to claim 1, comprising an unshaded region allowing light generated therein and emitted therefrom to exit the light emitting device and a shaded region not allowing light generated therein and emitted therefrom to exit the light emitting device.

5. The light emitting device according to claim 4, further comprising:
an insulating layer disposed between the second electrode pad and the second semiconductor layer to cover a region of the second semiconductor layer,
wherein the insulating layer spreads electric current injected through the second electrode pad such that the electric current flows evenly throughout the second semiconductor layer and the active layer.

6. The light emitting device according to claim 5, wherein the insulating layer is disposed on a lower region of the second semiconductor layer in the shaded region.

7. The light emitting device according to claim 6, wherein the second electrode pad contacts the second semiconductor layer in the unshaded region.

8. The light emitting device according to claim 1, wherein the first electrode pad has a smaller cross-sectional area than the first contact layer.

9. The light emitting device according to claim 1, wherein at least a side surface of the first semiconductor layer in the non-light emitting region includes a slope.

10. The light emitting device according to claim 1, wherein at least a side surface of the first contact layer includes a slope.

11. The light emitting device according to claim 1, wherein at least a side surface of the first electrode pad includes a slope.

12. The light emitting device according to claim 4, wherein the light emitting region partially overlaps the shaded region to form an overlapping region.

13. The light emitting device according to claim 12, wherein the upper surface of the first semiconductor layer in the overlapping region is placed higher than the upper surface of the first semiconductor layer in the light emitting region excluding the overlapping region.

14. The light emitting device according to claim 1, further comprising:
an insulating layer covering the upper surface of the second electrode pad and comprising a plurality of openings,
wherein the second electrode pad comprises a plurality of metal layers stacked one above another and partially or completely fills each of the plurality of openings of the insulating layer to be electrically connected to the second semiconductor layer.

15. The light emitting device according to claim 14, further comprising:
an upper current-spreading layer disposed on the first semiconductor layer to be electrically connected to a region of the first contact layer,
wherein the upper current-spreading layer comprises a plurality of divided regions extending from the first contact layer.

16. The light emitting device according to claim 15, wherein at least an opening of the plurality of openings of the insulating layer comprises an upper region gradually increased in diameter toward an upper end thereof and a lower region having a constant diameter.

17. The light emitting device according to claim 16, further comprising:
a second contact layer disposed between the second semiconductor layer and the second electrode pad,
wherein the second contact layer is disposed on the upper region of the at least an opening to be electrically connected to the second semiconductor layer and the second electrode pad.

18. The light emitting device according to claim 17, wherein an inner surface of the insulating layer including the upper region of the at least an opening comprises a curved surface.

19. The light emitting device according to claim 18, wherein, in a region, the upper current-spreading layer is disposed at both sides of the first contact layer with a space between the upper current-spreading layer and the first contact layer, and the second contact layer is disposed between the first contact layer and the upper current-spreading layer.

20. The light emitting device according to claim 14, wherein, in a region outside the second semiconductor layer, an upper surface of at least a metal layer of the plurality of metal layers is placed lower than a lower surface of the active layer.
